# EUROPEAN PATENT SPECIFICATION

(11) **EP 2 323 051 B1**
(45) Date of publication and mention of the grant of the patent: **06.07.2016**
(21) Application number: 10188504.4
(22) Date of filing: 22.10.2010
(51) Int. Cl.: G06F 17/50, G06T 19/00, G06F 17/30

(54) **Method and system for detecting and displaying graphical models and alphanumeric data**
Verfahren und System zur Erkennung und Anzeige graphischer Modelle und alphanumerischer Daten
Procédé et système pour détecter et afficher des modèles graphiques et des données alphanumériques

(30) Priority: 23.10.2009 IT MI20091836
(43) Date of publication of application: 18.05.2011
(73) Proprietor: Y.UPPIES' SERVICES S.p.a., 41126 Modena (IT)
(72) Inventor: Modena, Giuseppe, 41122, MODENA (IT); Francia, Pier Paolo, 41100, MODENA (IT)
(74) Representative: Tansini, Elio Fabrizio

(56) References cited:
- EP-A1- 1 443 431
- WO-A1-02/06988
- GB-A- 2 440 763

## Description

The present invention relates to a method of detecting and displaying two-dimensional and three-dimensional graphic models and alphanumeric data.

In particular, the method enables detection of elements in environments.

The invention also refers to a system having the same purposes as the associated method.

In the following the term "elements" is understood as indicating objects, rooms or the like disposed in environments, the latter comprising dwelling houses, firms, museums, industrial plants, etc.

The objects comprise equipment, furniture or the like in the above listed environments.

The following specification is provided with reference to the surveying of elements in a museum for the only purpose of making the description simpler.

It is known that up to now data survey of elements in environments has been carried out through measurement of the sides of the rooms of the reference environment made in the form of hypothetical polyhedron models and through a subsequent processing into a graphic format.

Alternatively, data survey is carried out through topographic instruments in which distances and angles are measured that are subsequently processed for automatic or semiautomatic display of same.

In the petrochemical sector, for surveying pipeline systems and plants, it is on the contrary used a mere laser scanning which offers more survey accuracy and immediateness.

Surveys of elements in environments have been up to now historically carried out for obtaining graphic representations in a two-dimensional or three-dimensional form.

Data tables and schedules or cards relating to the surveyed elements have been put beside these representations, which tables can be consulted also separately.

This great number of representations that are independent of each other have allowed a detailed view of the concerned element, but they remained inevitably limited due to the impossibility of integrating the different results in order to provide an overall view of the element itself.

Switching from a type of representation to another is not yet obtained in a quick and precise manner; a person skilled in the art is still studying the different representations and processing the information based on his/her ability and knowledge so as to have an overall view of the element in the environment.

Therefore the information can be fully understood only by the specialists in the field and those who are familiar with the traditional display systems, being on the contrary of difficult interpretation for most of the unqualified users.

Known surveys, in addition, generate data files of big sizes making integration of same difficult with any other interfacing program.
In addition, integration with third parties' applications is severely penalised.

Document GB 2440763 discloses a data federation system comprising a user data display section which has a classification and component specific information table, which is extracted from a three-dimensional (e.g. CAD) component database and a two-dimensional (e.g. CAD) component database, and a component attribute data table associated thereto. A federation control section controls data federation among a three-dimensional component data display section, two-dimensional component data display section and user data display section. A jump section acquires the classification or component specific information using the classification and component specific information table, retrieves the three-dimensional component database or two-dimensional component database by controlling the three-dimensional component data display section or two-dimensional component data display section, and displays an image display screen of the three-dimensional component data or two-dimensional component data of the retrieved component.

Document EP 1443431 discloses an integrated building production information system comprising design CAD's based on software of building, structure and equipment, and databases built in the outside separately from these design CAD's, said databases making an integrated DB-CAD system of building, structure and equipment as an execution-linked system in DB-CAD's sharing data of a standard database, wherein said integrated building production information system stores the information made compatible by three-dimensional superposition at the time of design into the shared database (DB) of the integrated DB-CAD system, and further receives and links information of this shared database to external systems such as a skeleton drawing CAD, a reinforcing bar and steel frame system and the like and makes execution information.

By reason of the above arguments, the main object of the present invention is to provide a method and a system allowing a better data integration and exchange between the different available representations.

It is a further aim of the invention to be able to easily and automatically carry out switching from one representation to another of the same element, so as to have a particular and at the same time overall view of the displayed element.

It is another aim of the invention to carry out switching between the different representations as quickly as possible and using the smallest amount of memory resources.

Another aim is to accomplish a method and a system of easy application and understanding, so that they can be not only used by persons skilled in the art.

A still further aim is to enable representation switchings both locally in the survey environment and remotely.

The foregoing and further aims are substantially reached by the method and system for detecting and displaying two-dimensional and three-dimensional graphic models and alphanumeric data according to that which is described in the appended claims.

The invention achieves the following advantages:
- better data integration and exchange between the different available representations;
- simple switching from a representation to another of the same element;
- better overall view of the displayed element;
- reduced use of memory resources for switching between the different representations;
- easy use and understanding;
- possibility of use locally in the survey environment and remotely.

The foregoing and other advantages of the invention will appear in greater detail in the description set out hereinafter of an embodiment given by way of nonlimiting example with reference to the accompanying drawings.

### Brief Description of the Drawings

Fig. 1 is a block diagram of the main steps of the method according to the present invention.
Figs. 2, 3 and 4 show reference screenshots of the different views of the method of the invention.

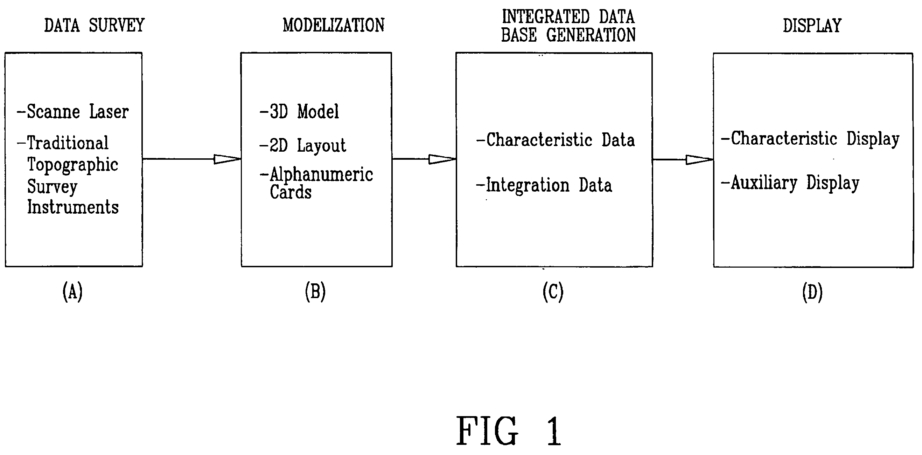

Shown in Fig. 1 is a block diagram of the method of detecting and displaying two-dimensional and three-dimensional graphical models and alphanumeric data, in particular elements at the inside of buildings.

Preferably, the elements can comprise objects, rooms, furniture pieces or the like.

Preferably, the elements can be divided into reference classes such as radiators, extinguishers, lamps or any other group of classifiable objects.

In the following example a method of detecting and displaying elements at the inside of a museum will be treated.

The first step is data survey (Step (a) in Fig. 1).

It can take place through traditional two-dimensional topographic survey means or the like or three-dimensional detection means (point clouds) representing the elements distributed in an environment or room.

Starting from the three-dimensional survey, preferably the detection means for detecting point clouds comprises one or more laser scanners to provide a three-dimensional model according to the X, Y and Z coordinates.

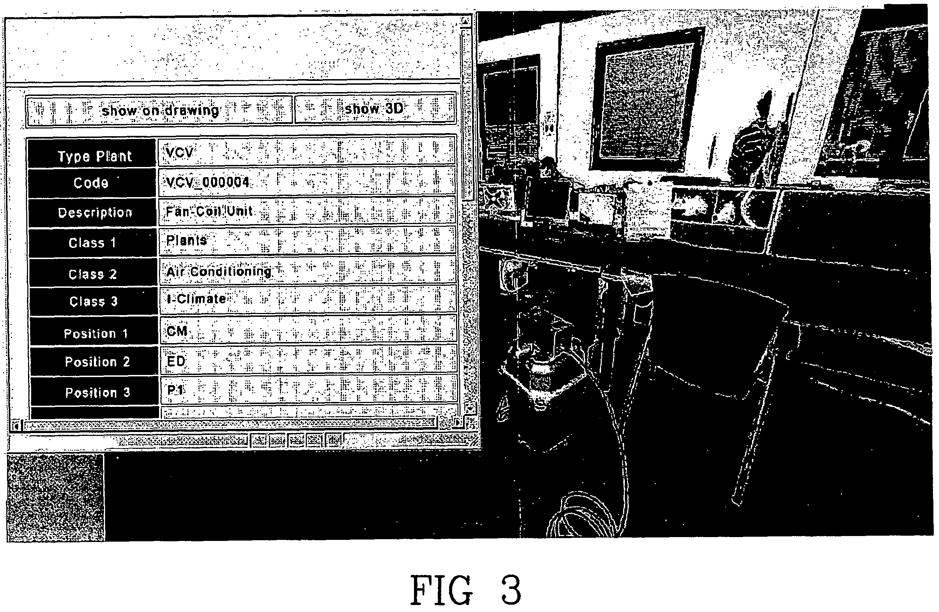

An example of a three-dimensional model survey is shown in Fig. 3.

A laser scanner is a mechanical electro-optical device that, through the progressive scan technique, allows an element to be automatically detected in its characteristic sizes.

The result of a scanning operation is the above mentioned point clouds, of the X, Y, Z coordinates, that can be directly displayed on the computer monitor as "Three-dimensional picture" formed with millions of points describing the surface of the detected element in detail and from which colorimetric and size information can be drawn.
Preferably, scanning is carried out in each room of the environment to be detected, in particular said museum, and takes place using a phase-difference laser scanning instrument of an ultra-high speed enabling to carry out quick and accurate surveys. Scanning can be a black and white or colour scanning.

The scanner, having a 360° x 310° field of view, enables a whole room to be scanned and surveyed in an environment having a limited number of stations (and even only one station) referred to as shooting points.

The point cloud is stored in a computer the task of which is to make three-dimensional models (also identified as 3D models) of elements or, in particular, of objects in a room according to the X, Y and Z coordinates.

Known specific programs integrate the point clouds obtained through the laser scanner with pictures acquired during the survey, providing an instrument of view offering a panning shot on the surveyed element.

The standard browsing tools enable dynamic movement in the representations; in fact, the following operations are possible:
- in case of rendering relative to surveys carried out at differentiated acquisition points (i.e. in different views), selection of the specific view is possible;
- carrying out a zooming on the selected representation;
- rotating a selected representation at an arbitrary rotation angle, within the detection angles (generally smaller than 360°).

Going on now with the two-dimensional survey, the traditional survey instruments, on the contrary, allow accomplishment of two-dimensional layouts or plans (also referred to as 2D) for the representation of survey elements in an environment according to the X and Y coordinates.

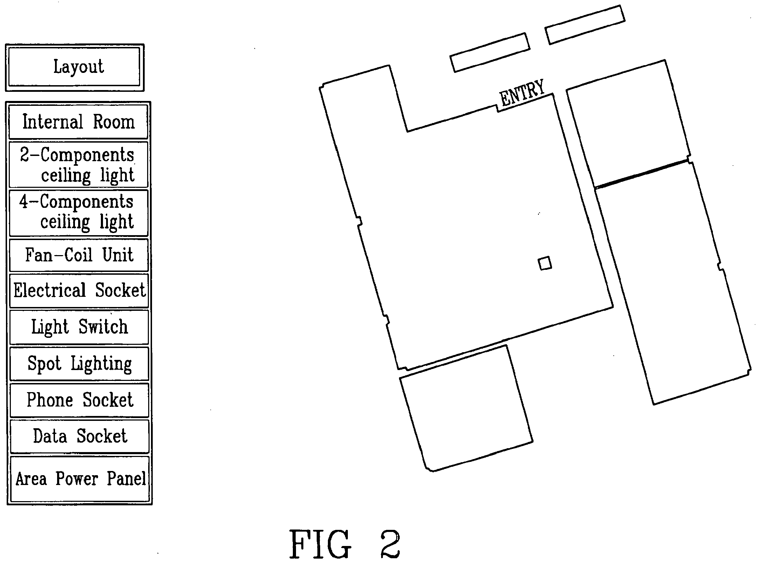

Shown in Fig. 2 is an example of a two-dimensional survey.

In this case too, switching from the survey instruments to the accomplished model (two-dimensional layout) takes place through a computer.

Programs such as the CAD enable, starting from the architectonic structure and by means of a representation model, to create two-dimensional layouts comprising the survey elements in an environment.

The representation model is built through closed polygonal lines of the environments/rooms or the elements therein present.

The two-dimensional representation of a survey element describes the geometrical features, in a structured and analytical manner, of the element and the components thereof that are considered as important and the position of same relative to a reference plane.

Thus each element can be geometrically identified.

There are also other non-graphical representation forms showing the features of the elements such as alphanumeric cards; by these cards some identification features (identification code, destination of use, etc.) can be associated with each element as well as descriptive qualities, if judged of importance.

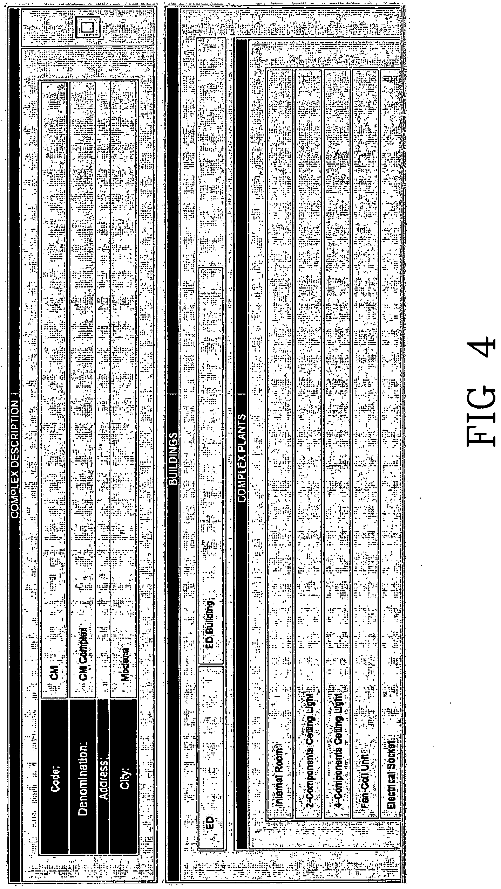

An example of these cards is shown in Figs. 3 and 4.

The geometric and alphanumeric information provided by the two-dimensional representation and the alphanumeric cards respectively, is not directly available in the three-dimensional representation unless hard processing activities are carried out on the three-dimensional model through suitably prepared programs.

The standard market instruments for consulting the two-dimensional layouts and the alphanumeric cards contemplate browsing functionalities that are ascribable to:
- the possibility of carrying out zooming on the two-dimensional representation;
- the possibility of moving, on the two-dimensional representation (panning);
- the possibility of querying the alphanumeric features associated with graphically represented components (blocks);
- the possibility of highlighting elements having specific alphanumeric features (layers).

Each element of interest (heating bodies, extinguishers, lamps, etc.) is graphically represented (through graphic symbols) on the layout through positioning inside the rooms, and the information is reproduced on the alphanumeric cards.

With reference to the example of the preferred embodiment of the invention, in detection and representation of objects within a museum, elements (objects and rooms) are surveyed as well as the corresponding physical structure; in other words the survey concerns:
- works of art, both paintings and sculptures;
- frescos and wall decorations;
- pieces of furniture;
- showcase with exposed objects.

The three-dimensional model and two-dimensional layout, in a dwf format for example, generated by one or more computers, will be used for displaying the elements through a displaying interface, for instance a monitor associated with one or more computers.

In particular, these displays can be also remotely published, through the web.

In addition to two-dimensional layouts and three-dimensional models, also an alphanumeric technical card of the elements that are present is carried out.

Preferably, the technical card is obtained by means of a computer, the same computer for processing the survey data for example, which is provided for organisation of the graphical and alphanumeric data of the elements.

Data are usually either manually inserted or acquired in the form of a table through known programs.

Different specifications may suggest either use of a single computer for carrying out the two-dimensional and three-dimensional displays and the cards or, alternatively, distribution of the whole work according to a parallel architecture allowing a further increase in the processing/display speed.
Each processing unit can consist of a single electronic device, suitably programmed for performing the above described functions, and different modules of the processing units can correspond to the hardware and/or software routines being part of the programmed device. The method of the invention therefore, once the elements in an environment have been detected or surveyed, can allow representation models of these elements to be created (Step (b) in Fig. 1).

In other words, the method is specifically oriented to detection and representation of two-dimensional and three-dimensional graphic models and alphanumeric data referring to elements in an environment.

The method therefore allows provision of:
- two-dimensional layouts for the representation of elements according to the X and Y coordinates;
- alphanumeric data cards for the representation of elements according to the X and Y coordinates;
- three-dimensional models for the representation of elements according to the X, Y and Z coordinates.

Starting from these models it is possible to generate an integrated data base (Step (c) in Fig. 1) comprising characteristic data of the elements represented in two-dimensional layouts and/or alphanumeric data cards.

The characteristic data are also identifiable as those geometric and/or alphanumeric data that are not submitted to any processing in importing them from the model/card to the integrated data base.

Advantageously, according to the invention, the integrated data base further comprises integration data obtained through processing of the characteristic data. The integration data comprise one or more of the following information:
- the X and Y coordinates of the polygonal lines representing the individual rooms in the environment;
- the X and Y coordinates of the polygonal lines representing the objects of linear nature, such as single wall portions;
- the X, Y and Z coordinates of the points corresponding to the space position of the individual elements, such as a radiator, taking into account two different situations:
   - during survey, in addition to the coordinates X and Y, the coordinate Z too has been detected; or
   - during survey, only the X and Y coordinates have been detected; in this case the Z coordinate is taken based on a predetermined value for the component; preferably, this predetermined value is coincident with the average height of location of the type of element in the detected environment. Associated with each type of element is a predetermined value obtained with the same modalities.
- the coordinates X and Y of the points corresponding to the position of the openings bringing two different contiguous rooms/environments into communication with each other;
- the coordinates X, Y and Z of the corresponding points of the survey tools with the laser scanner.

Advantageously, according to the invention, processing of the characteristic data is specific to the survey environment.

In other words, the same subject of information, the polygonal lines representing a room for example, is inserted in the context of the specific survey environment generating numerically-different integration data.

Advantageously, according to the invention, starting from a characteristic display of the elements in at least a first one of the available representations, it is possible to pass to an auxiliary display of the same elements in a second one of the available representations, obtained from at least a first one of the representations through a geometric and/or positional and/or semantic processing of the integrated data base.

Preferably, the geometric processing is obtained at least through relational intersection operators of the characteristic data.

The "intersection" operator, starting from a predetermined straight line, enables the intersection thereof with a circular area to be found, which circular area has a predetermined radius and centre corresponding to an assigned point.

Preferably, the positional processing is obtained through at least relational proximity operators between said characteristic data.

The operator of closest to", starting from a predetermined selection point and a series of points in space, allows identification of the point in space which is at a minimum distance from the selection point.

Preferably, the semantic processing is obtained at least through relational operators of "containing" and/or "contained in" between said characteristic data.

The operator of "contained in", starting from a selection point, allows identification of the closed polygonal line containing it.

The operator of "containing", starting from a predetermined closed polygonal line, allows identification of the points belonging to a predetermined assembly, that are contained therein.

In summary, it is possible to start from any first display based on simple unprocessed characteristic data and therefrom switch to an auxiliary display with more specific processed data or a greater amount of data.

The advantageous availability of such an integrated data base enables an improvement in the integration and data exchange between the different available representations by merely switching from one representation to another of the same element, and a better overall view of the displayed element.

Some examples of characteristic starting displays will be now described as well as the corresponding auxiliary displays generated through processing of the integrated data base of the invention (Step (d) in Fig. 1).

### Switching from three-dimensional (3D) to two-dimensional (2D) displays and/or alphanumeric card (example in Fig. 3)

The characteristic element display step is obtained by selecting an element in the three-dimensional model.

This selection allows identification of at least the X and Y coordinates of the selection point of the element; in another hypothesis, the element is identified by all the available coordinates, X, Y and Z.

The auxiliary display step of the selected element is obtained by identifying in the alphanumeric data cards, the alphanumeric features associated with the selected element and obtained through geometrical and/or positional and/or semantic processing of the integrated data base.

In this case the auxiliary display step of the selected element, in turn, comprises the steps of:
- determining a current room in the environment in which the selected element is;
   this step utilises the relational operator of "contained in";
- if an indication of the type of element to be sought has been given, providing a specific search filter;
- if the selected element is detected in the two-dimensional plan or layout without the co-ordinate Z, the predetermined co-ordinate for the type of this element is applied; in other words, as already said, the average height of location of the type of element in the survey environment is applied;
- determining the equation of the ideal straight line connecting the shooting point with the selection point of the element;
- seeking for the elements of the selected type/s that are in the vicinity (i.e. within a predetermined range) of the thus determined straight line, "travelling" along the latter starting from the shooting point and in the direction of the selection point of the element; this step utilises the relational operator of "intersection"
- identifying the card of the element being closest to said straight line which was detected by means of said search; this step utilises the relational operator of "close to".

### Switching from two-dimensional (2D) display or alphanumeric card to three-dimensional (3D) display

The characteristic display step of an element is obtained by selecting an element in the two-dimensional layout or the alphanumeric data cards; this enables at least the X, Y coordinates of a selection point of the element to be identified.

The auxiliary display step of the elements is obtained by identifying, in the three-dimensional model, the element selected in the two-dimensional layout or the alphanumeric data cards, obtained through a geometric and/or positional and/or semantic processing of the integrated data base.

In this case, the auxiliary display step of the selected element in turn comprises the steps of:
- determining a current room in the environment in which the selected element is;
   this step utilises the relational operator of "contained in";
- if the selected elements are detected in the two-dimensional plan without the co-ordinate Z, the predetermined co-ordinate for the type of this element is applied;
- determining the shooting point being closest to the co-ordinates of the selected element, as described in the following at chapter "Recovery of the most appropriate view for a given element";
- based on the co-ordinates of the element and the shooting point, determining the vertical and horizontal rotation angles for centring to the best the rendering in the three-dimensional model of the element selected by the user;
- generating a symbol (an "X" of blue colour, for example) on the three-dimensional image at the X, Y and Z co-ordinates of said selected element.

### Highlighting of all the elements having specific features

The characteristic display step of an element is obtained by selecting a type of element (radiators, extinguishers, lamps, etc., for example) in the two-dimensional layout or the alphanumeric data cards.

The auxiliary display step of the elements is obtained by identifying, in the three-dimensional model, all elements of the selected type obtained through a geometric and/or positional and/or semantic processing of the integrated data base.

In this case, the auxiliary display step of the selected element in turn comprises the steps of:
- determining the room in the environment with which the current shooting point is associated; this step utilises the relational operator of "contained in";
- identifying the elements belonging to the room in the current environment between all the elements of the type of selected element.
- generating a symbol (an "X" of blue colour, for example) on the three-dimensional image at each identified element.

### Recovery of the most appropriate view for a given element

The characteristic display step of an element is obtained by selecting an element in the two-dimensional layout or the alphanumeric data cards.

The auxiliary display step of the elements is obtained by identifying, in the three-dimensional model, the most appropriate view for the selected element that is obtained through a geometric and/or positional and/or semantic processing of the integrated data base.

In this case, the auxiliary display step of the selected element in turn comprises the steps of:
- determining the environment (room) to which the element belongs; this step utilises the relational operator of "contained in";
- identifying all the shooting points (and related co-ordinates X, Y and Z) belonging to that room;
- identifying the shooting point being closest to the selected element using the X and Y co-ordinates of the element and those of said detected shooting points; this step utilises the relational operator "closest to".

### Possibility of moving on the three-dimensional (3D) representation starting from the three-dimensional (3D) views or the two-dimensional layout (2D)

The characteristic display step of an element is obtained by selecting an element in the two-dimensional layout or the alphanumeric data cards.

The auxiliary display step of the elements is obtained by identifying, in the three-dimensional model, the most appropriate view for the selected element that is obtained through a geometric and/or positional and/or semantic processing of the integrated data base.

In this case the auxiliary display step of the selected element in turn comprises the steps of:
- shifting the three-dimensional image close to a selected view in the two-dimensional representation;
- shifting the three-dimensional image close to a predetermined one of the views belonging to a selected room in the two-dimensional representation (or in the alphanumeric list of the rooms).

### Browsing between the different views

The characteristic display step of an element is obtained by selecting a point of an element in the three-dimensional model.

The auxiliary display step of the element is obtained by identifying, in the three-dimensional model, the view that is closest to the selected element which is obtained through a geometric and/or positional and/or semantic processing of the integrated data base.

In this case, the auxiliary display step of the selected element in turn comprises the steps of:
- determining whether the selected point is within one of the polygonal lines corresponding to each of the detected rooms; this step utilises the relational operator of "contained in";
- if the selected point belongs to the current room or belongs to no room, seeking for a possible intercommunication opening in the vicinity of a straight line connecting a shooting point to the selected point; this step utilises the relational operator of "close to";
- seeking for a possible opening in the vicinity of the selected point by identifying, in the cards of alphanumeric data, the alphanumeric features associated with said opening obtained through the geometric and/or positional and/or semantic processing of the integrated data base; this step utilises the relational operator of "close to";
- from the views belonging to the room found by the method of the polygonal lines, identifying the view the X, Y and Z co-ordinates of which are closest to said selected point, if the search for the polygonal lines has rendered the current room or another room, and that of the openings has been unsuccessful; this step utilises the relational operator of "close to".

As an alternative to the last mentioned step:
- bringing the three-dimensional image onto a room different from the current one, if on the contrary an intercommunication opening has been found between two rooms (one of which, as already pointed out, is said current room);
- moving the selected point back by a predetermined distance in the direction of the shooting point if neither method (polygonal lines and openings) has been successful; preferably the predetermined distance is equal to about 40 cm;

- determining whether this new point is contained in a room or not by adopting the already described method of the polygonal lines; this step utilises the relational operator of "contained in";
- returning a message of error, if the last attempt too has been unsuccessful.

The structure of the method as above described also enables the unskilled user to have a very precise overall view with immediate and easy consulting of the elements/rooms in the survey environment.

Shown in Figs, 2, 3 and 4 are examples of these displays.

The described displays can be made available to the user through display interfaces that can be consulted also via the Internet or are present on dedicated web sites. This allows both a person skilled in the art and a common user to consult data in remote relative to the location of the applications generating said data.

A processing system carries out implementation of all local or distributed functions of the method of the invention; it also carries out publication of the displays generated according to the invention.

From the above description, operation of the system according to the invention can be inferred.

The system is interfaced with the assembly of premises to be viewed that enable consulting of same according to a tree diagram: building complex, building, storey, in addition to consulting by type of elements/works, by individual work or author.

Once the museum area has been identified, it can be displayed on the two-dimensional layout and then identified in the municipal space and the path for reaching it can be defined.

If a "virtual" visit is decided in the museum area, one of the proposed possibilities is to consult the layout of the room or space provided with the list of the objects present therein (supplied by the alphanumeric card), reproducing the rooms and works that are exposed therein. An example of this representation is shown in Fig. 2.

While browsing is carried out within the layout, different possibilities for going on with consulting exist, among which:
- by a click, the technical card and high-definition photo of each of the registered works can be opened;
- by a click, the work within the three-dimensional model can be viewed, and then placement of same can be seen (Fig. 3);
- by a click, the room can be viewed and browsing within the three-dimensional model can be carried out.

The clicking operation allows start of one of the following procedures: detection or survey/display/display switching of the coordinates of the objects, as previously described.

Browsing within the three-dimensional model takes place through rotation of the mouse; the model can be visited moving from one room to another and carrying out rotation in all directions because the only dark point is at the base of the scanning instrument.

Other possible operations are zooming, returning to the start position and printing.

While browsing is being carried out within the three-dimensional model, different possibilities are offered for going on consulting, among which:
- by a click, opening the technical card (switching from the three-dimensional model or two-dimensional layout to the alphanumeric data card) and the high-definition photo of each of the registered works that are visible in the three-dimensional model;
- from the technical card, going back (switching from the card to the two-dimensional layout) to the layout and identifying the work position;
- going back to the layout with identification of the visited work in the layout.

## Claims

1. A method of detection and representation of two-dimensional and three-dimensional graphic models and alphanumeric data referring to elements in a survey environment, the method comprising the steps of:
- providing:
two-dimensional layouts or plans for the representation of said elements according to the co-ordinates (X) and (Y);
• cards of alphanumeric data for the representation of said elements according to the co-ordinates (X) and (Y) ;
• three-dimensional models for the representation of said elements according to the co-ordinates (X), (Y) and (Z) based on laser scans of the survey environment taken from at least one shooting point;
- generating an integrated data base comprising:
• characteristic data of said elements represented in two-directional plans and/or cards of alphanumeric data;
• integration data obtained through processing of said characteristic data specific to said survey environment;
- carrying out a characteristic display of said elements in at least a first one of said representations;
- carrying out an auxiliary display of said elements in at least a second one of said representations obtained from at least a first one of said representations through the geometric and/or positional and/or semantic processing of said integrated data base.
wherein:
- said characteristic display step of said elements is obtained through selection of an element in said three-dimensional model;
- said auxiliary display step of said elements is obtained by identifying, in the cards of alphanumeric data, the alphanumeric features associated with said selected element, obtained through the geometric and/or position and/or semantic processing of the integrated data base;
wherein:
- during said characteristic display step of said elements, selection of an element in said three-dimensional model allows identification of at least the co-ordinates X, Y of a selection point of said element;
- said auxiliary display step of said elements comprises the steps of:
• determining a current room in the environment in which the selected element is;
• if an indication of the type of element to be sought is given, providing a specific search filter;
• if the selected element is detected in the two-dimensional plan without the co-ordinate Z, a predetermined co-ordinate for the type of this element is applied;
• determining the equation of the ideal straight line connecting the shooting point with said selection point of said element;
• seeking for the elements of the selected type/s that are in the vicinity of the thus determined straight line, "travelling" along the latter starting from the shooting point and in the direction of said selection point of said element;
• identifying the card of said element being closest to said straight line which was detected by means of said search.

2. A detection and representation method as claimed in claim 1 wherein said geometric processing is obtained through relational intersection operators of said characteristic data.

3. A detection and representation method as claimed in claim 1, wherein said positional processing is obtained through relational proximity operators between said characteristic data.

4. A detection and representation method as claimed in claim 1, wherein said semantic processing is obtained through relational containing and/or contained in operators between said characteristic data.

5. A detection and representation method as claimed in anyone of the preceding claims, wherein said integration data comprise at least one of:
- the co-ordinates (X and Y) of the polygonal lines representing the individual rooms in the environment;
- the co-ordinates (X and Y) of the polygonal lines representing the objects of a linear nature;
- the co-ordinates (X, Y and Z) of the points corresponding to the spatial position of the individual elements, if during the survey step also the co-ordinate Z has been detected, in addition to the co-ordinates X and Y;
- the co-ordinates (X and Y) of the points corresponding to the position of the crossing passages bringing two different contiguous rooms/environments into communication with each other;
- the co-ordinates (X, Y and Z) of the points corresponding to the position of the laser scanner survey instruments .

6. A detection and representation method as claimed in claim 5 wherein, if during the survey step only the co-ordinates (X and Y) have been detected, then the co-ordinate Z is adopted, based on a predetermined value for the element.

## Patentansprüche

1. Verfahren zur Erfassung und Darstellung zweidimensionaler und dreidimensionaler grafischer Modelle und alphanumerischer Daten, die sich auf Elemente in einer Survey-Umgebung beziehen, wobei das Verfahren folgende Schritte umfasst:
- Bereitstellen:
zweidimensionaler Layouts oder Pläne für die Darstellung der Elemente nach den Koordinaten (X) und (Y) ;
Karten alphanumerischer Daten für die Darstellung der Elemente nach den Koordinaten (X) und (Y);
dreidimensionaler Modelle für die Darstellung der Elemente nach den Koordinaten (X), (Y) und (Z), basierend auf Laserscans der Survey-Umgebung, die von mindestens einem Aufnahmepunkt aufgenommen wurden;
- Generieren einer integrierten Datenbank, umfassend:
charakteristische Daten der in bidirektionalen Ebenen und/oder Karten alphanumerischer Daten dargestellten Elemente;
die Integration der erhaltenen Daten durch die Verarbeitung der für jede Survey-Umgebung spezifischen charakteristischen Daten;
- Erstellen einer charakteristischen Anzeige der Elemente in mindestens einer ersten der Darstellungen;
- Erstellen einer Hilfsanzeige der Elemente in mindestens einer zweiten der Darstellungen, erhalten aus mindestens einer ersten der Darstellungen durch das geometrische und/oder positionsbezogene und/oder semantische Verarbeiten der integrierten Datenbank. wobei:
- der Schritt der charakteristischen Anzeige der Elemente erhalten wird durch die Auswahl eines Elements im dreidimensionalen Modell;
- der Schritt der Hilfsanzeige der Elemente erhalten wird, indem in den Karten alphanumerischer Daten die alphanumerischen Eigenschaften, die mit dem ausgewählten Element verknüpft sind, identifiziert werden, erhalten durch das geometrische und/oder positionsbezogene und/oder semantische Verarbeiten der integrierten Datenbank;
wobei:
- während des Schritts der charakteristischen Anzeige der Elemente die Auswahl eines Elements im dreidimensionalen Modell die Identifizierung von mindestens der Koordinaten X, Y eines Auswahlpunkts des Elements erlaubt;
- der Schritt der Hilfsanzeige der Elemente folgende Schritte umfasst:
Bestimmen eines aktuellen Raums in der Umgebung, in dem sich das ausgewählte Element befindet;
wenn eine Angabe des zu suchenden Elementtyps vorliegt, Bereitstellen eines speziellen Suchfilters;
wenn das ausgewählte Element in der zweidimensionalen Ebene ohne die Z-Koordinate erfasst wird, wird eine vorgegebene Koordinate für den Typ dieses Elements übernommen;
Bestimmen der Gleichung der idealen geraden Linie zur Verbindung des Aufnahmepunkts mit dem Auswahlpunkts des Elements;
Suchen der Elemente des/der ausgewählten Typs/Typen, die sich in der Nähe der so bestimmten geraden Linie befinden, durch deren Entlangfahren, ausgehend vom Aufnahmepunkt und in Richtung des Auswahlpunkts des Elements;
Identifizieren der Karte des Elements, die der geraden Linie, die durch diese Suche erfasst wurde, am nächsten ist.

2. Verfahren zur Erfassung und Darstellung nach Anspruch 1, wobei das geometrische Verarbeiten durch Vergleichsschneidungsoperatoren der charakteristischen Daten erhalten wird.

3. Verfahren zur Erfassung und Darstellung nach Anspruch 1, wobei das positionsbezogene Verarbeiten durch Vergleichsproximitätsoperatoren zwischen den charakteristischen Daten erhalten wird.

4. Verfahren zur Erfassung und Darstellung nach Anspruch 1, wobei das semantische Verarbeiten durch Vergleichsoperatoren enthält und/oder enthalten in zwischen den charakteristischen Daten erhalten wird.

5. Verfahren zur Erfassung und Darstellung nach einem der vorhergehenden Ansprüche, wobei die Integrationsdaten mindestens jeweils enthalten:
- die Koordinaten (X und Y) der Polygonlinien, die die einzelnen Räume in der Umgebung darstellen, und/oder
- die Koordinaten (X und Y) der Polygonlinien, die die Objekte linearer Art darstellen;
wobei die Koordinaten (X, Y und Z) der Punkte der räumlichen Position der einzelnen Elemente entsprechen, wenn während des Survey-Schritts auch die Z-Koordinate erfasst wurde, zusätzlich zu den Koordinaten X und Y; wobei die Koordinaten (X und Y) der Punkte der Position der Kreuzpassagen entsprechen, die zwei unterschiedliche angrenzende Räume/Umgebungen in Kommunikation miteinander bringen;
wobei die Koordinaten (X, Y und Z) der Punkte der Position der Laserscanner-Surveyinstrumente entsprechen.

6. Verfahren zur Erfassung und Darstellung nach Anspruch 5, wobei, wenn während des Survey-Schritts nur die Koordinaten (X und Y) erfasst wurden, die Z-Koordinate, basierend auf einem vorgegebenen Wert für das Element, übernommen wird..

## Revendications

1. Procédé de détection et de représentation de modèles graphiques bidimensionnels et tridimensionnels et de données alphanumériques se rapportant aux éléments dans un environnement de relevé, le procédé comprenant les étapes de :
- fournir :
des mises en forme bidimensionnelles ou plans destinés à la représentation desdits éléments selon les coordonnées (X) et (Y) ;
des cartes de données alphanumériques pour la représentation desdits éléments selon les coordonnées (X) et (Y) ;
des modèles tridimensionnels pour la représentation desdits éléments selon les coordonnées (X), (Y) et (Z) se basant sur des balayages laser de l'environnement de relevé pris à partir d'au moins un point de prise de vue ;
- générer une base de données intégrée comprenant :
les données caractéristiques desdits éléments représentés dans des plans bidimensionnels et/ou des cartes de données alphanumériques ;
l'intégration des données obtenues par le traitement desdites données caractéristiques spécifiques au dit environnement de relevé ;
- effectuer un affichage caractéristique desdits éléments dans au moins une première desdites représentations ;
- effectuer un affichage secondaire desdits éléments dans au moins une seconde desdites représentations obtenue à partir d'au moins une desdites représentations par l'intermédiaire d'un traitement géométrique et/ou de la position et/ou sémantique de ladite base de données intégrée.
dans lequel :
- ladite étape d'affichage caractéristique desdits éléments est obtenue par le biais du choix d'un élément dans ledit modèle tridimensionnel ;
- ladite étape d'affichage secondaire desdits éléments est obtenue grâce à l'identification, dans les cartes des données alphanumériques, des caractéristiques alphanumériques associées au dit élément choisi, obtenues grâce au traitement géométrique et/ou de la position et/ou sémantique de la base de données intégrée ;
dans lequel :
- lors de ladite étape d'affichage caractéristique desdits éléments, le choix d'un élément dans ledit modèle tridimensionnel permet au moins l'identification des coordonnées X, Y d'un point de sélection dudit élément ;
- ladite étape d'affichage secondaire desdits éléments comprend les étapes de :
déterminer une pièce actuelle dans l'environnement dans lequel l'élément choisi se trouve ;
si une indication du type d'élément à rechercher est donnée, fournir un filtre de recherche spécifique ;
si l'élément choisi est détecté dans le plan bidimensionnel sans la coordonnée Z, une coordonnée prédéfinie est appliquée pour ce type d'élément ;
déterminer l'équation de la droite optimale reliant le point de prise de vue au dit point de sélection dudit élément ;
rechercher pour les éléments du/des type(s) sélectionné(s) se trouvant à proximité de la droite ainsi déterminée, « en parcourant » celle-ci à partir du point de prise de vue et dans la direction dudit point de sélection dudit élément ;
identifier la carte dudit élément étant le plus proche par rapport à ladite droite ayant été détecté par le biais de ladite recherche.

2. Procédé de détection et de représentation selon la revendication 1, dans lequel ledit traitement géométrique est obtenu par l'intermédiaire d'opérateurs relationnels d'intersection desdites données caractéristiques.

3. Procédé de détection et de représentation selon la revendication 1, dans lequel ledit traitement de la position est obtenu par l'intermédiaire d'opérateurs relationnels de proximité entre lesdites données caractéristiques.

4. Procédé de détection et de représentation selon la revendication 1, dans lequel ledit traitement sémantique est obtenu par l'intermédiaire d'opérateurs relationnels de contenance et/ou contenus entre lesdites données caractéristiques.

5. Procédé de détection et de représentation selon l'une quelconque des revendications précédentes, dans lequel lesdites données d'intégration comprennent au moins un des éléments suivantes :
- les coordonnées (X et Y) des lignes polygonales représentant toutes les pièces dans l'environnement ;
- les coordonnées (X et Y) des lignes polygonales représentant tous les objets d'une nature linéaire ; les coordonnées (X, Y et Z) des points correspondant à la position dans l'espace de tous les éléments si, en plus des coordonnées X et Y, la coordonnée Z a été détectée lors de l'étape de relevé ;
les coordonnées (X et Y) des points correspondants à la position des passages transversaux mettant en communication deux pièces/environnements contigus ;
les coordonnées (X, Y et Z) des points correspondant à la position des instruments de relevé à balayage laser.

6. Procédé de détection et de représentation selon la revendication 5, dans lequel si lors de l'étape de relevé seules les coordonnées (X et Y) ont été détectées, alors la coordonnée Z est adoptée en se basant sur une valeur prédéfinie pour l'élément.
